# EUROPEAN PATENT SPECIFICATION

(11) **EP 2 200 825 B1**
(45) Date of publication and mention of the grant of the patent: **22.02.2012**
(21) Application number: 08840478.5
(22) Date of filing: 14.10.2008
(51) Int. Cl.: B41C 1/05

(54) **CREATING A UNIFORM IMAGING SURFACE**
ERZEUGUNG EINER EINHEITLICHEN BILDGEBUNGSOBERFLÄCHE
CRÉATION D'UNE SURFACE D'IMAGERIE UNIFORME

(30) Priority: 17.10.2007 US 873502
(43) Date of publication of application: 30.06.2010
(73) Proprietor: Eastman Kodak Company, Rochester, NY 14650-2201 (US)
(72) Inventor: AVIEL, David, 49510 Petach Tikva (IL)
(74) Representative: Weber, Etienne Nicolas
(86) International application number: PCT/US2008/011715
(87) International publication number: WO 2009/051696

(56) References cited:
- GB-A- 2 043 274
- US-A- 5 916 403
- US-A1- 2004 129 158
- US-A1- 2006 027 113

## Description

### FIELD OF THE INVENTION

This present invention relates to an apparatus and methods for creating a uniform imaging surface by fastening flexographic printing plates mounted on a drum.

### BACKGROUND OF THE INVENTION

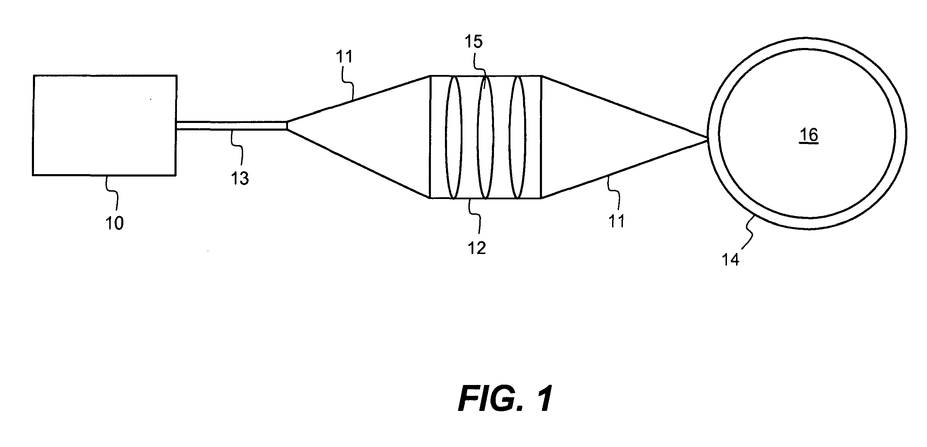

Flexographic printing plates are imaged on special optical-mechanical plate makers. The flexographic plate or sleeve, usually made from rubber based material, is placed on a drum for imaging. Due to its flexible nature, the flexographic plate, when mounted on the imaging drum 16 as illustrated in Figure 1, has a non-uniform plate surface. This fact introduces a major disadvantage, since it requires an optical imaging system with auto focus means to overcome the non-uniformity of the imaging plate.

Referring to Figure 1, the laser source 10 emits a laser beam 11 via the attached waveguide 13. Laser beam 11 enters lens system 12, and impinges on flexographic printing plate 14. Often laser beam 11 will be out of focus on flexographic printing plate 14 forming out of focus dots. This requires refocusing laser beam 11. The focusing is achieved by changing the position of an optical element in the optical path. Common practice today is to change the position of the lens system 12, thus changing the focus of beam 11 on the printing plate, thereby forming a well balanced dot on the surface of the printing plate.

The auto focus method described above dynamically adjusts the optical path to track the surface of the flexographic printing plate 14. The changing working distance results in sophisticated optical systems, which are needed to compensate for the total indicated runout (TIR), for mis-alignment between drum rotation axis and head motion axis and plate surface non uniformity. This is costly, both in terms of exposure time as well as additional cost for equipping the system with auto focus means.

### SUMMARY OF THE INVENTION

Briefly, according to one aspect of the present invention an apparatus for creating a uniform imaging surface on a flexographic plate or flexographic sleeve mounted on a drum and comprises a light source; a transparent drum; and a lens system for focusing a beam from the light source through the transparent drum onto the flexographic plate or sleeve.

These and other objects, features, and advantages of the present invention will become apparent to those skilled in the art upon a reading of the following detailed description when taken in conjunction with the drawings wherein there is shown and described an illustrative embodiment of the invention.

### BRIEF DESCRIPTION OF THE DRAWINGS

Figure 1 is a schematic illustrating a prior art flexographic imaging system equipped with auto focus means.
Figure 2 is a schematic illustrating a flexographic imaging system equipped with a transparent drum to form a uniform imaging surface on a flexographic plate.
Figure 3 is a schematic illustrating a flexographic imaging system equipped with a hollow transparent drum to form a uniform imaging surface on a flexographic plate.
Figure 4 is a schematic illustrating a perspective view of a flexographic plate solid plate fastener configuration.
Figure 5 is a schematic illustrating a perspective view of another flexographic plate hollow plate fastener configuration.
Figure 6 is a schematic illustrating top view of a hollow drum with a trapezoid cross section.

### DETAILED DESCRIPTION OF THE INVENTION

The present invention describes a plate fastening system, which brings uniformity to the plate surface prior to imaging, thus removing the need for expensive auto focusing means.

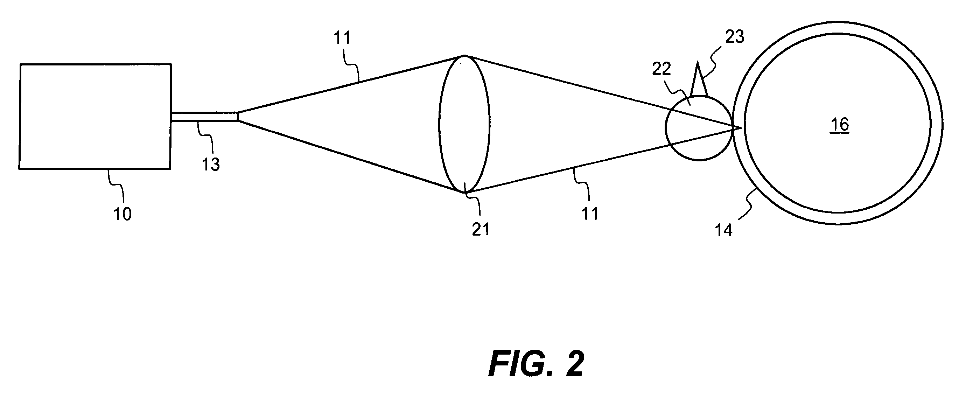

Referring to Figure 2, the present invention has a fixed laser source 10 which directs laser beam 11 through a lens 21. The beam will impinge on a spot on flexographic printing plate 14. Laser beam 11, before reaching flexographic printing plate 14, which is mounted on imaging drum 16, passes through fastening transparent drum 22.

The fastening transparent drum 22 is mounted such that a fixed distance is maintained between a surface of the imaging drum 16 and an axis transparent drum 16. When imaging drum 16 and fastening transparent drum 22 are rotating, fastening transparent drum 22 applies pressure on flexographic printing plate 14 approximately equal to the pressure that a printing press would apply to the printing plate. The result is generation of a uniform surface on the imaging area of flexographic printing plate 14, thus removing the need to use auto focus means for each line of imaging. The transparent material used for fastening transparent drum 22 enables a laser beam 11 to pass through the fastening transparent drum 22, prior to impinging on flexographic printing plate 14 for imaging.

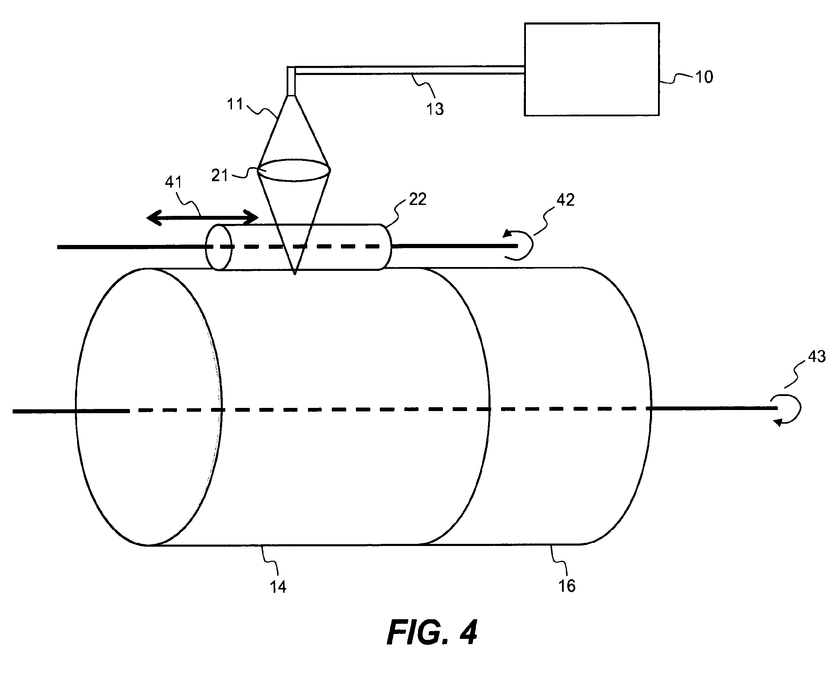

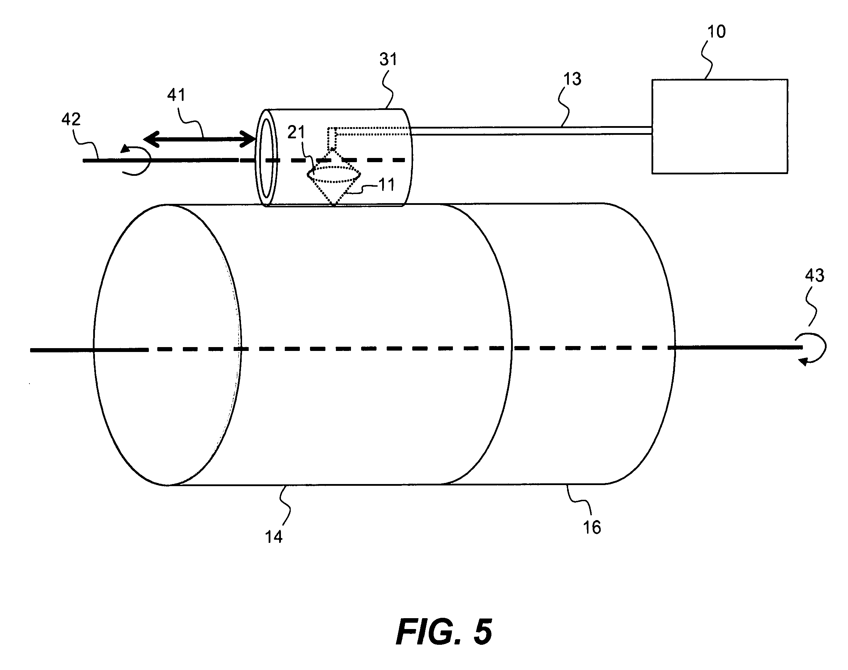

In one embodiment, the fastening transparent drum 22 (or fastening hollow transparent drum 31) is shorter than imaging drum 16. In order to fasten the entire length of flexographic printing plate 14, which is mounted on imaging drum 16, fastening transparent drum 22 is moved along imaging drum 16 in fastening drum moving direction 41 as is illustrated in Figures 4 and 5. Imaging drum 16 and fastening transparent drum 22 (or fastening hollow transparent drum 31) rotate around parallel imaging drum rotation axis 43 and fastening drum rotation axis 42 respectively.

Fastening drum cleaning element 23, shown in Figure 2, attached to fastening transparent drum 22, and comprises a liquid, for example water, supply and a wiping tissue, for example a brush. Fastening drum cleaning element 23 applies water on fastening transparent drum 22 while fastening transparent drum 22 rotates. In addition, it uses a brush to wipe accumulated plate debris on fastening transparent drum 22. The cleaning process serves two purposes, debris removal and cleaning fastening transparent drum 22. The constant cleaning of fastening transparent drum 22 is important in order to maintain its transparency for achieving optimal laser radiation through fastening transparent drum 22.

In another embodiment drum 22 can be built from gradient index lenses (GRIN), which will allow fastening transparent drum 22 to function as a lens in addition to its fastening function. The gradient index lenses will focus the light through a precisely controlled radial variation of the lens material's index of refraction from the optical axis to the edge of the lens, or fastening transparent drum 22.

Engraving is done while the flexographic printing plate 14 is under pressure similar to the pressure applied on the plate by the printing press. This means that plate engraving is performed under conditions similar to when the plate is mounted on the printing press. This causes flexographic printing plate 14 dimensions be very close to the plate dimensions when mounted on the printing press, which yields a more accurate compensation for dot gain and variations in dot gain due to plate non-uniformity and plate drum run-out.

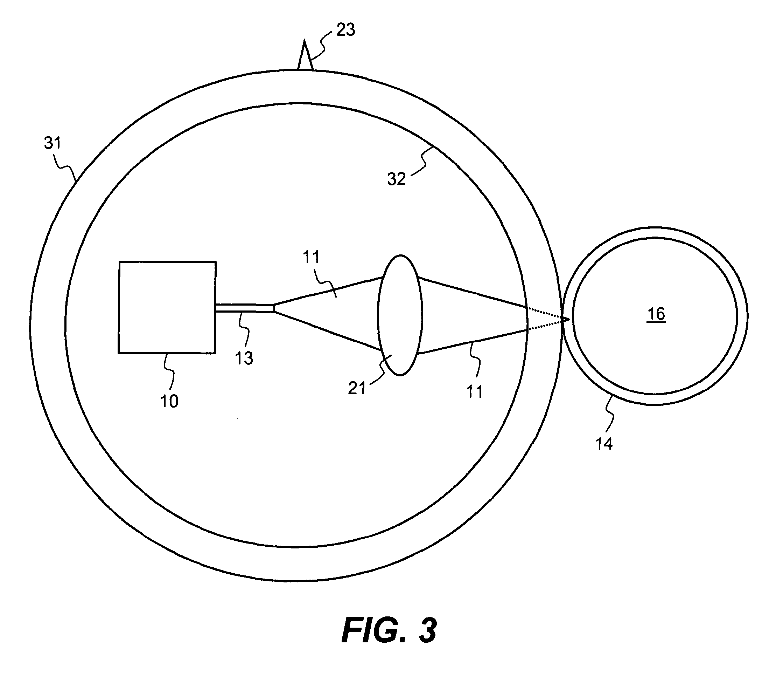

In another embodiment of this invention, a hollow fastening transparent drum 31 is used, as is illustrated in Figure 3. The optical elements 10, 11, 13 and 21 are connected through the hollow volume of the hollow fastening transparent drum 31. This embodiment has several advantages. The internal drum surface 32 of the fastening hollow transparent drum 31, does not pick up dirt, generated by the plate debris. It is also less prone for scratches, and thus can better maintain the optical qualities of the hollow fastening transparent drum 31. Therefore the inner drum surface 32 can be prepared in various forms such as convex or concave to equip the hollow fastening transparent drum 31 with required optical features to act as a lens.

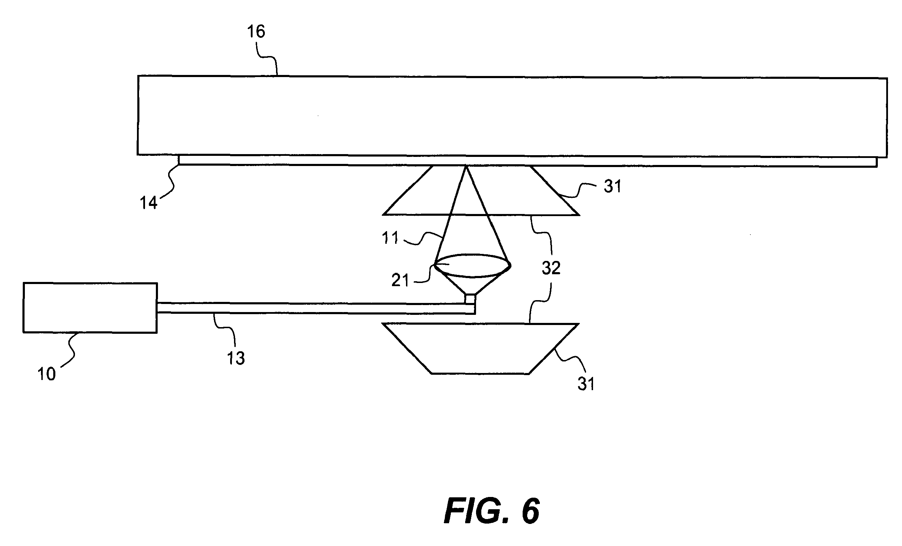

The required thickness of the hollow fastening transparent drum 31 may be on the order of the size of the imaged plate area, so that the imaged area on the plate is sufficiently pressed to achieve a uniform plate surface. In addition the cross section of the hollow fastening transparent drum 31 may be square, circular, trapezoid, or any other geometrical shape. Figure 6 shows a cross section of a trapezoid shape of fastening hollow transparent drum 31.

## Claims

1. An apparatus for creating a uniform imaging surface on a flexographic plate or flexographic sleeve (14) mounted on an imaging drum (16) comprising:
an imaging light source (10) for emitting a beam (11);
a fastening transparent drum (22, 31) for applying pressure on the flexographic plate or flexographic sleeve (14) mounted on said imaging drum (16) during imaging; wherein the fastening transparent drum (22, 31) comprises optical elements to function as a lens for focusing the beam (11) from the light source (10) through the fastening transparent drum (22, 31) onto the flexographic plate or sleeve (14), for imaging.

2. The apparatus of claim 1, wherein a drum cleaning element (23) cleans the fastening transparent drum (22, 31).

3. The apparatus of claim 2, wherein the drum cleaning element (23) comprises a liquid supply and a brush for removing debris from the fastening transparent drum.

4. The apparatus of claim 1, wherein the fastening transparent drum (22) comprises a gradient index lens.

5. The apparatus of claim 1, wherein the fastening transparent drum comprises a solid optical material.

6. The apparatus of claim 1, wherein the imaging drum (16) and the fastening transparent drum rotate around parallel axes.

7. The apparatus of claim 1, wherein the fastening transparent drum applies uniform pressure to the flexographic plate or sleeve.

8. The apparatus of claim 1, wherein the fastening transparent drum has optical power in a beam direction.

9. The apparatus of claim 1, wherein the fastening transparent drum is a hollow drum (31) that maintains a uniform pressure on the flexographic plate or sleeve (14), the hollow transparent drum (31) comprising:
an imaging light source (10) providing a beam of light (11) to an interior portion of the hollow transparent drum (31); and
a lens system (21) for focusing the beam from the light source (10) through the hollow transparent drum (31) onto the imaging surface of the flexographic plate or sleeve (14).

10. The apparatus of claim 9, wherein a cross section of the hollow fastening transparent drum (31) is selected from a group comprised of a square, a circle, or a trapezoid.

11. The apparatus of claim 1, wherein the pressure is similar to a pressure applied to the flexographic plate or sleeve by a printing press.

12. A method for creating a uniform imaging surface on a flexographic plate or a flexographic sleeve mounted on an imaging drum (16) comprising:
producing an imaging beam (11);
compressing the imaging surface of the flexographic plate with a fastening transparent drum (22, 31); and
focusing the imaging beam (11) on the imaging surface through the fastening transparent drum (22, 31), for imaging.

## Patentansprüche

1. Gerät zum Erzeugen einer gleichförmigen Abbildungsfläche auf einer flexografischen Platte oder einer flexografischen Hülse (14), die auf einer Abbildungstrommel (16) gelagert sind, mit:
einer Abbildungslichtquelle (10) zum Abgeben eines Lichtstrahls (11);
einer transparenten Andrucktrommel (22, 31) zum Anwenden von Druck auf die flexografische Platte oder die flexografische Hülse (14), die während des Abbildungsvorgangs auf der Abbildungstrommel (16) gelagert sind; wobei die transparente Andrucktrommel (22, 31) optische Elemente aufweist, die als Linse zum Fokussieren des Lichtstrahls (11) von der Lichtquelle (10) durch die transparente Andrucktrommel (22, 31) auf die flexografische Platte oder Hülse (14) wirken zum Zwecke der Abbildung.

2. Gerät nach Anspruch 1, worin ein Trommelreinigungselement (23) die transparente Andrucktrommel (22, 31) reinigt.

3. Gerät nach Anspruch 2, worin das Trommelreinigungselement (23) einen Flüssigkeitsvorrat und eine Bürste aufweist zum Entfernen von Ablagerungen von der transparenten Andrucktrommel.

4. Gerät nach Anspruch 1, worin die transparente Andrucktrommel (22) eine Gradientenindex-Linse aufweist.

5. Gerät nach Anspruch 1, worin die transparente Andrucktrommel ein festes optisches Material umfasst.

6. Gerät nach Anspruch 1, worin die Abbildungstrommel (16) und die transparente Andrucktrommel um parallele Achsen drehbar sind.

7. Gerät nach Anspruch 1, worin die transparente Andrucktrommel einen gleichförmigen Druck auf die flexografische Platte oder Hülse ausübt.

8. Gerät nach Anspruch 1, worin die transparente Andrucktrommel eine optische Verstärkung in einer Strahlrichtung aufweist.

9. Gerät nach Anspruch 1, worin die transparente Andrucktrommel eine hohle Trommel (31) ist, die einen gleichförmigen Druck auf die flexografische Platte oder Hülse (14) beibehält, wobei die hohle transparente Trommel (31) umfasst:
eine Abbildungslichtquelle (10), die einen Lichtstrahl (11) auf einen inneren Abschnitt der hohlen transparenten Trommel (31) sendet; und
ein Linsensystem (21) zum Fokussieren des Strahls von der Lichtquelle (10) durch die hohle transparente Trommel (31) auf die Abbildungsfläche der flexografischen Platte oder Hülse (14).

10. Gerät nach Anspruch 9, worin ein Querschnitt der hohlen, transparenten Andrucktrommel (31) ausgewählt wird aus einer Gruppe, die aus einem Quadrat, einem Kreis oder einem Trapez besteht.

11. Gerät nach Anspruch 1, worin der Druck einem Druck ähnelt, der mittels einer Druckpresse auf die flexografische Platte oder Hülse ausgeübt wird.

12. Verfahren zum Erzeugen einer gleichförmigen Abbildungsfläche auf einer flexografischen Platte oder einer flexografischen Hülse, die auf einer Abbildungstrommel (16) gelagert sind, mit:
Erzeugen eines Abbildungsstrahls (11);
Zusammendrücken der Abbildungsfläche der flexografischen Platte mit einer transparenten Andrucktrommel (22, 31);
Fokussieren des Abbildungsstrahls (11) auf der Abbildungsfläche durch die transparente Andrucktrommel (22, 31) zum Zwecke der Abbildung.

## Revendications

1. Dispositif destiné à créer une surface de formation d'image uniforme sur une plaque flexographique ou un manchon flexographique (14) monté sur un tambour de formation d'image (16) comprenant :
une source lumineuse de formation d'image (10) destinée à émettre un faisceau (11) ;
un tambour transparent de fixation (22, 31) destiné à appliquer une pression sur la plaque flexographique ou le manchon flexographique (14) monté sur ledit tambour de formation d'image (16) au cours de la formation d'image ; dans lequel le tambour transparent de fixation (22, 31) comprend des éléments optiques pour fonctionner comme une lentille afin de focaliser le faisceau (11) provenant de la source lumineuse (10) à travers le tambour transparent de fixation (22, 31) sur la plaque ou le manchon flexographique (14), en vue d'une formation d'image.

2. Dispositif selon la revendication 1, dans lequel un élément de nettoyage de tambour (23) nettoie le tambour transparent de fixation (22, 31).

3. Dispositif selon la revendication 2, dans lequel l'élément de nettoyage de tambour (23) comprend une alimentation en liquide et un balai destiné à retirer les débris du tambour transparent de fixation.

4. Dispositif selon la revendication 1, dans lequel le tambour transparent de fixation (22) comprend une lentille à gradient d'indice.

5. Dispositif selon la revendication 1, dans lequel le tambour transparent de fixation comprend un matériau optique solide.

6. Dispositif selon la revendication 1, dans lequel le tambour de formation d'image (16) et le tambour transparent de fixation tournent autour d'axes parallèles.

7. Dispositif selon la revendication 1, dans lequel le tambour transparent de fixation applique une pression uniforme sur la plaque ou au manchon flexographique.

8. Dispositif selon la revendication 1, dans lequel le tambour transparent de fixation présente une puissance optique dans une direction de faisceau.

9. Dispositif selon la revendication 1, dans lequel le tambour transparent de fixation est un tambour creux (31) qui maintient une pression uniforme sur la plaque ou le manchon flexographique (14), le tambour transparent creux (31) comprenant :
une source lumineuse de formation d'image (10) fournissant un faisceau de lumière (11) sur une partie intérieure du tambour transparent creux (31) ; et
un système de lentille (21) destiné à focaliser le faisceau provenant de la source lumineuse (10) à travers le tambour transparent creux (31) sur la surface de formation d'image de la plaque ou du manchon flexographique (14).

10. Dispositif selon la revendication 9, dans lequel une section transversale du tambour transparent de fixation creux (31) est sélectionnée parmi un groupe constitué d'un carré, d'un cercle ou d'une forme trapézoïde.

11. Dispositif selon la revendication 1, dans lequel la pression est similaire à une pression appliquée sur la plaque ou au manchon flexographique par une presse d'impression.

12. Procédé destiné à créer une surface de formation d'image uniforme sur une plaque flexographique ou un manchon flexographique monté sur un tambour de formation d'image (16) comprenant :
la production d'un faisceau de formation d'image (11) ;
la compression de la surface de formation d'image de la plaque flexographique à l'aide d'un tambour transparent de fixation (22, 31) ; et
la focalisation du faisceau de formation d'image (11) sur la surface de formation d'image à travers le tambour transparent de fixation (22, 31), en vue d'une formation d'image.
